(19) Europäisches Patentamt
European Patent Office
Office européen des brevets

(11) Veröffentlichungsnummer: **0 277 555 B1**

# (12) EUROPÄISCHE PATENTSCHRIFT

(45) Veröffentlichungstag der Patentschrift: **08.04.92**

(51) Int. Cl.5: **C08F 220/36**, C08F 230/08, G03F 7/004, //(C08F220/36, 230:08),(C08F230/08,220:36)

(21) Anmeldenummer: **88100892.4**

(22) Anmeldetag: **22.01.88**

## (54) Copolymerisate mit o-Nitrocarbinolestergruppierungen und Verfahren zur Herstellung von Zweilagenresisten sowie von Halbleiterbauelementen.

(30) Priorität: **24.01.87 DE 3702035**

(43) Veröffentlichungstag der Anmeldung:
**10.08.88 Patentblatt 88/32**

(45) Bekanntmachung des Hinweises auf die Patenterteilung:
**08.04.92 Patentblatt 92/15**

(84) Benannte Vertragsstaaten:
**AT BE CH DE FR GB IT LI NL**

(56) Entgegenhaltungen:
**DE-A- 2 922 746**
**DE-A- 3 326 036**
**DE-A- 3 415 791**
**DE-C- 2 150 691**
**US-A- 4 481 049**

(73) Patentinhaber: **BASF Aktiengesellschaft**
**Carl-Bosch-Strasse 38**
**W-6700 Ludwigshafen(DE)**

(72) Erfinder: **Schwalm, Reinhold, Dr.**
**Am Huettenwingert 53**
**W-6706 Wachenheim(DE)**
Erfinder: **Binder, Horst**
**Haendelstrasse 3-5**
**W-6840 Lampertheim(DE)**

**EP 0 277 555 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Copolymerisate mit o-Nitrocarbinolestergruppierungen, die nach dem Belichten alkalisch ausgewaschen werden können und im Sauerstoffplasma resistent sind sowie Verfahren zur Herstellung von Zweilagenresisten und Halbleiterbauelementen auf deren Grundlage sowie ein Verfahren zur Herstellung der Copolymerisate.

Zur Herstellung von Halbleiterbaulementen werden Mehrlagenresiste, besonders Dreilagenresiste, eingesetzt, insbesondere zur Herstellung von Resiststrukturen mit Dimensionen <2 µm auf Substraten mit unterschiedlicher Topografie. Diese Resiste bestehen aus einer unteren Polymerschicht auf dem Substrat, welche hauptsächlich dazu dient, die Oberfläche des Substrates zu planarisieren. Die Dicke der Planarisierungsschicht variiert je nach Höhe der Stufen auf dem Substrat und kann bis zu 4 µm betragen. Die Schicht muß nicht inhärent lichtempfindlich sein, sollte sich jedoch bei spezieller Plasmabehandlung, z.B. im Sauerstoffplasma, vollständig abtragen lassen. Dann wird eine Zwischenschicht aufgebracht, die so gewählt wird, daß sie bei spezieller Plasmabehandlung, z.B. im Sauerstoffplasma, wesentlich langsamer geätzt wird als die darunterliegende Planarisierungsschicht. Als oberste Schicht wird ein lichtempfindliches Material, z.B. ein kommerziell erhältlicher Diazochinon-Novolak-Photoresist, aufgebracht, welches bildmäßig belichtet und entwickelt werden kann. Der Dreilagenresist wird dann strukturiert, indem die oberste Schicht gemäß den bekannten lithografischen Verfahren belichtet und entwickelt wird, so daß Reliefstrukturen entstehen. Das erzeugte Muster wird dann mit Hilfe eines geeigneten Plasmas, z.B. fluorokohlenwasserstoffhaltigen Plasmen, in die Zwischenschicht übertragen. Das so erzeugte Muster in der Zwischenschicht dient dann als Maske für die weitere Strukturübertragung in die Planarisierungsschicht, beispielsweise mit Hilfe eines Sauerstoffplasmas. Die Vorteile dieser Dreilagentechnik liegen darin, daß man eine relativ dicke Planarisierungsschicht anwenden kann, ohne an Auflösung zu verlieren, weiterhin darin, daß die obere lichtempfindliche Schicht sehr dünn sein kann (0,1 µm bis 1 µm), wobei die Auflösung mit geringerer Schichtdicke besser wird. Nachteilig ist jedoch die große Zahl der benötigten Prozeßschitte für den Aufbau und die Strukturierung der Dreilagenresiste.

Um die Anzahl der Prozeßschritte zu reduzieren, wurde eine Reihe von Materialien vorgeschlagen, die die Eigenschaften der beiden oberen Lagen kombinieren, d.h. sowohl Lichtempfindlichkeit als auch Plasmaresistenz in einer Schicht vereinigen. Solche Materialien enthalten beispielsweise Organosilizium-, Organozinn- oder Organotitangruppen im Molekül.

Einen Überblick über siliziumhaltige Resists für Zweilagensysteme gibt z.B. H. Gokan in SPIE-International Society for Optical Engineering, Vol. 539, Advances in Resist Technology and Processing II, Seiten 62-68 (1985). Weiterhin sind bekannt z.B. Polysiloxane (I. Shaw, Polym. Eng. Scie., 23, Seite 1054 (1983)), Polysilane (D. Hofer, SPIE Vol. 469, Seiten 16-23 (1984)), Trimethylsilylstyrol-Copolymere (S.A. McDonald, Microelectronic Eng. 1, Seiten 269-293 (1983) und M. Suzuki, I. Electrochem. Soc. 130, Seiten 1962-64 (1983)) als lichtempfindliche, plasmaresistente Polymere. Die meisten der organosiliziumhaltigen Polymeren sind negativ arbeitende Resists, da Siliziumalkyl- oder Siliziumvinyl-Gruppen unter Belichtung leicht zur Vernetzung neigen. Positiv arbeitende Resists mit Organosiliziumgruppen sind jedoch auch bekannt, z.B. die Polysilane, silylierte Polystyrole (Buiguez, Microcircuit Engineering 1984, A. Heuberger, H. Beneking, Eds., Academic Press 1985, S. 471-481). Silizium enthaltende Oximester der Methacrylsäure (US 4 433 044), silylierte Novolake (US 4 521 274) sowie Siliziumderivate von Poly-(methylmethacrylat) (US 4 481 049). Die erwähnten Polymeren zeigen alle Resistenz im Sauerstoffplasma, wenn ein bestimmter Mindestgehalt an Siliziumatomen im Molekül enthalten ist. Jedoch hat jedes System für sich spezielle Nachteile bezüglich Lichtempfindlichkeit, Entwickelbarkeit oder thermischer Stabilität. Beispielsweise sind die Trimethylsilylstyrol-Copolymere und die silylierten Polymethylmethacrylat-(= PMMA)Derivate nur mit organischen Lösungsmitteln entwickelbar. Die silylierten Novolak-Resiste sind zwar mit alkalischen Lösungsmitteln auswaschbar, aber für die Belichtung im "tiefen" UV ($\lambda$ = 190 nm - 300 nm) nicht geeignet.

Lichtempfindliche, alkaliauswaschbare Polymere, die o-Nitrocarbinolestergruppen im Molekül enthalten, sind z.B. aus DE-A-22 42 394, DE-A-21 50 691 und DE-A-33 26 036 bekannt. Diese Polymeren lassen sich zwar mit tiefem UV-Licht (z.B. $\lambda$ = 248 nm) strukturieren, werden jedoch im Sauerstoffplasma vollständig abgebaut.

Aufgabe der vorliegenden Erfindung war es, im DUV-(= Deep UV)-Bereich ($\lambda$ = 190 nm -300 nm) lichtempfindliche Polymere, die wäßrig bzw. alkalisch auswaschbar sind und Resistenz im Sauerstoffplasma zeigen, zur Verfügung zu stellen.

Es wurde nun gefunden, daß diese Aufgabe durch spezielle Copolymerisate gelöst werden kann, die sowohl o-Nitrocarbinolestergruppierungen als auch mindestens 6 Gew.% Silizium enthalten. Diese Polymeren sind besonders geeignet für die Herstellung von Zweilagenresistsystemen mit der Charakteristik von Dreilagenresisten zur Fertigung von Halbleiterbauelementen.

Gegenstand der vorliegenden Erfindung sind Copolymerisate, die einpolymerisiert enthalten
(a) 5 bis 50 Mol.% mindestens einer Verbindung der allgemeinen Formel (I)

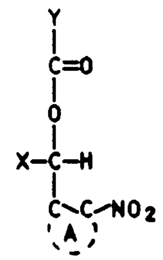

(I),

worin A für ein aromatisches oder heteroaromatisches, gegebenenfalls substituiertes Ringsystem mit 5 bis 14 Ringgliedern,
X für Wasserstoff, einen Alkylrest mit 1 bis 8 Kohlenstoffatomen, einen gegebenenfalls substituierten Aryl- oder Aralkylrest und
Y für einen ethylenisch ungesättigten Rest mit 2 bis 6 Kohlenstoffatomen stehen,
(b) 95 bis 50 Mol.% mindestens einer copolymerisierbaren olefinisch ungesättigten Silizium enthaltenden organischen Verbindung,
(c) 0 bis 20 Mol.% einer oder mehrerer copolymerisierbarer olefinisch ungesättigter Carbonsäuren mit 3 bis 6 Kohlenstoffatomen,
(d) 0 bis 25 Mol.% einer oder mehrerer weiterer von (a), (b) und (c) verschiedener olefinisch ungesättigter, copolymerisierbarer organischer Verbindungen, deren Homopolymerisate im Wellenlängenbereich zwischen 250 und 400 nm transparent sind,
mit der Maßgabe, daß die Summe der unter (a) bis (d) genannten Prozentzahlen 100 ist, und das Copolymerisat einen Siliziumgehalt von >6 Gew.% aufweist.

Der Rest Y in der allgemeinen Formel (I) steht dabei vorzugsweise für einen der Reste

$-CH=CH_2$ , 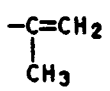 , $-CH=CH-COOH$ , $-CCl=CCl-COOH$ , 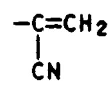 ,

$-CH=CHCH_3$ , 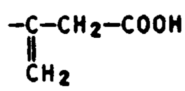 , 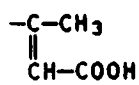 , 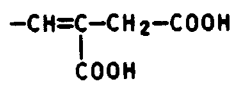 oder

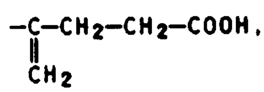, insbesondere für den Rest 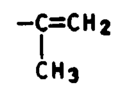

und der Rest A für Phenyl.

Als der o-Nitrocarbinolestergruppierung der Formel (I) zugrundeliegendes Carbinol sind o-Nitrobenzylalkohol, Nitro-6-chlorbenzylalkohol, 2-Nitro-4-cyanobenzylalkohol, α-Methyl-o-nitrobenzylalkohol, α-Phenyl-o-nitrobenzylalkohol oder α-(o-Nitrophenyl)-o-Nitrobenzylakohol bevorzugt.

Als copolymerisierbare olefinisch ungesättigte Silizium enthaltende Verbindung (b) sind Derivate des Styrols oder α-Methylstyrols, insbesondere 4-Trimethylsilylstyrol sowie Derivate der Acrylsäure oder Methacrylsäure, insbesondere Trimethylsilylmethacrylat, Trimethylsilylmethyl-methacrylat, 3-Methacryloxypropyl-bis-(trimethylsiloxy)methylsilan, 3-Methacryloxy-propylpentamethyldisiloxan, 3-Methacryloxypropyl-tris-(trimethylsiloxy-)silan, 3-Methacryloxypropyl-trimethoxysilan und 2-(Trimethylsilyl)-ethyl-methacrylat und als Komponente (c) Acrylsäure oder Methacrylsäure bevorzugt.

Gegenstand der vorliegenden Erfindung ist auch ein Verfahren zur Herstellung eines Zweilagenresists, wobei als untere Lage ein im Sauerstoffplasma abbaubares Polymer, beispielsweise ein konventioneller Novolak-Resist, und als obere Schicht eines der erfindungsgemäßen Copolymerisate eingesetzt wird.

Eine vorteilhafte Ausführungsform dieses Verfahrens zur Herstellung eines Zweilagenresists besteht darin, daß das erfindungsgemäße Copolymerisat zunächst strukturiert und dann das Muster mit Hilfe eines Plasmas, vorzugsweise eines Sauerstoffplasmas, in die untere Schicht übertragen wird.

Die erfindungsgemäßen Copolymerisate können beispielsweise Struktureinheiten der allgemeinen Formel (II) enthalten

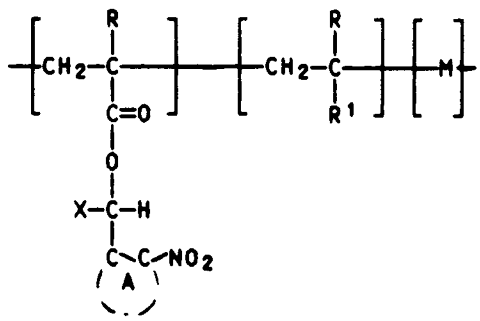

(II),

worin X und A die gleiche Bedeutung haben wie in Formel (I), R für Wasserstoff oder eine Alkylgruppe, vorzugsweise für eine Methylgruppe steht, der Rest $R^1$ Siliziumatome enthält, wobei $R^1$ ein substituierter aromatischer Rest oder eine Estergruppierung ($-COOR^2$) sein kann, worin $R^2$ dann Silizium enthält, und gegebenenfalls M für den einpolymerisierten Rest einer oder mehrerer weiterer einpolymerisierter olefinisch ungesättigter Monomerkomponenten, die teilweise auch Carboxylgruppen enthalten können, stehen kann.

Mit den erfindungsgemäßen Polymeren können Zweilagenresiste mit planarer Oberfläche hergestellt werden. Die erfindungsgemäßen Copolymerisate lassen sich mit DUV-Licht bildmäßig strukturieren und wäßrig bzw. alkalisch auswaschen. Das erzeugte Muster läßt sich dann mit Hilfe eines Sauerstoffplasmas in die untere Planarisierungsschicht übertragen. Die als Maske dienenden Resiststrukturen werden aufgrund des Siliziumgehaltes nur wenig abgetragen.

Zu den Aufbaukomponenten der erfindungsgemäßen Copolymerisate ist im einzelnen folgendes auszuführen.

(a) Als Verbindungen der allgemeinen Formel (I)

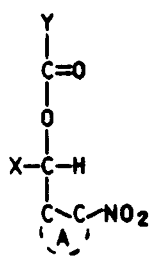

(I),

worin A für ein ein- oder mehrkerniges aromatisches oder heteroaromatisches, gegebenenfalls substituiertes Ringsystem mit 5 bis 14 Ringgliedern,

X für Wasserstoff, einen Alkylrest mit 1 bis 8 Kohlenstoffatomen, einen gegebenenfalls substituierten Aryl- oder Aralkylrest und

Y für einen ethylenisch ungesättigten Rest mit 2 bis 6 Kohlenstoffatomen stehen,

kommen beispielsweise solche in Frage, in denen der Rest Y in der allgemeinen Formel (I) für einen der Reste

$-CH=CH_2$ , 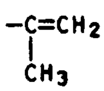 , $-CH=CH-COOH$ , $-CCl=CCl-COOH$ , 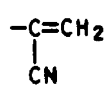 ,

$-CH=CHCH_3$ , 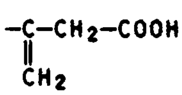 , 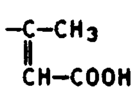 , 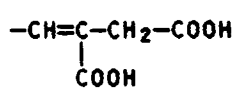 oder

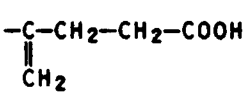

steht.

Dabei werden unter aromatischen Ringsystemen A insbesondere Benzol und substituierte Benzole verstanden. Der Benzolring kann ein- oder mehrfach substituiert sein, beispielsweise durch $C_1$- bis $C_8$-Alkyl, insbesondere Methyl, durch $C_1$- bis $C_6$-Alkoxy, insbesondere Methoxy, durch Halogen, wie Chlor, durch Nitro- oder Amino- oder Monoalkyl- und Dialkylaminogruppen sowie durch Sulfogruppen. Es kommen auch entsprechend substituierte und unsubstituierte mehrkernige Benzolderivate, wie Naphthalin, Anthracen, Anthrachinon oder Phenanthren in Betracht. Als heteroaromatisches Ringsystem A sind insbesondere Pyridin und dessen Derivate zu nennen.

Als den o-Nitrocarbinolestergruppierungen zugrunde liegende aromatische oder heteroaromatische o-Nitrocarbinole haben sich beispielsweise die folgenden Gruppierungen besonders bewährt: o-Nitrobenzyl-, 6-Nitroveratryl-, 2-Nitro-4-aminobenzyl-, 2-Nitro-4-dimethylaminobenzyl-, 2-Nitro-4-methylaminobenzyl-, 2-Nitro-5-dimethylaminobenzyl-, 2-Nitro-5-aminobenzyl-, 2-Nitro-4,6-dimethoxibenzyl-, 2,4-Dinitrobenzyl-, 3-Methyl-2,4-dinitrobenzyl-, 2-Nitro-4-methylbenzyl-, 2-Nitro-4-methylbenzyl-, 2,4,6-Trinitrobenzylalkohol sowie 2-Nitrobenzhydrol, 2,2′-Dinitrobenzhydrol, 2,4-Dinitrobenzhydrol oder 2,2′,4,4′-Tetranitrobenzhydrol. Ebenso geeignet sind beispielsweise 2-Nitro-3-hydroximethylnaphthalin, 1-Nitro-2-hydroximethylnaphthalin, 1-Nitro-2-hydroximethylanthrachinon oder 2-Nitro-3-hydroxymethylpyridin.

Den erfindungsgemäßen Copolymerisaten liegen, wie oben bereits ausgeführt o-Nitrocarbinolester von olefinisch ungesättigten Carbonsäuren als Monomere zugrunde, wobei als ethylenisch ungesättigte Mono- oder Dicarbonsäuren beispielsweise Acrylsäure, Methacrylsäure, Maleinsäure, Dichlormaleinsäure, Fumarsäure, Crotonsäure, Itaconsäure sowie Methylenglutarsäure verwendet werden können.

Die o-Nitrocarbinolester von olefinisch ungesättigten Carbonsäuren können nach bekannten Methoden der organischen Chemie, wie z.B. Umsetzung der Säurechloride mit o-Nitrocarbinolen oder durch direkte säurekatalyiserte Veresterung hergestellt werden (vgl. z.B. DE-A 21 50 691).

Besonders bevorzugte o-Nitrocarbinolestermonomere sind o-Nitrobenzyl-acrylat, o-Nitrobenzyl-methacrylat, o-Nitro-α-methyl-benzyl-(meth)acrylat, 2-Nitro-6-chlor-α-methyl-benzyl-(meth)acrylat.

Die erfindungsgemäßen Copolymerisate enthalten die o-Nitrocarbinolestermonomeren (a) in einer Menge von 5 bis 50, vorzugsweise 8 bis 30 Mol.% einpolymerisiert.

(b) Als copolymerisierbare olefinische ungesättigte Silizium enthaltende organische Verbindungen, die also Siliziumatome kovalent gebunden enthalten, eignen sich beispielsweise solche, die substituierte aromatische Reste der allgemeinen Formel (III)

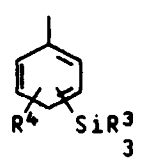

(III),

worin $R^3$ und $R^4$ untereinander gleich oder verschieden sein können und für Alkylgruppen mit 1 bis 6 Kohlenstoffatomen, Arylgruppen, wie Phenyl, Aralkylgruppen mit 7 bis 10 Kohlenstoffatomen, z.B. Methylphenyl-, stehen, wobei $R^4$ zusätzlich auch für Wasserstoff stehen kann, vorzugsweise 4-Trimethylsilyl-phenyl-, 4-Triethylsilyl-phenyl- und 4-Triphenylsilyl-phenyl-Reste enthalten sowie solche, bei denen das Siliziumatom nicht direkt an den aromatischen Kern, sondern über einen aliphatischen "Spacer" $-(CH_2)_x-$, wobei x = 1, 2 oder 3 sein kann, oder über ein Heteroatom, wie z.B. Sauerstoff oder Stickstoff mit dem aromatischen Rest verbunden ist, beispielsweise Trimethylsilyl-oxyethyl-phenyl-, Bis-(trimethylsilyl)-amino-phenyl-, 4-Trimethylsilylmethyl-phenyl-, 4-Trimethylsilyl-oxy-phenyl-Reste oder oder solche mit Estergruppierungen

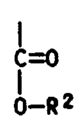

worin der Rest $R^2$ die das Siliziumatom tragende Gruppe repräsentiert und als Reste $R^2$ folgende Molekülgruppen bevorzugt sind: Trimethylsilyl-, Trimethylsilylmethyl-, 2-(Trimethyl-silyl)-ethyl-, 3-(Trimethylsilyl)-propyl-, 3-(Pentamethyldisiloxy)-propyl-, 3-bis-(trimethylsiloxy)-methylsilyl-propyl-, 3-tris-(trimethylsiloxy)-silyl-propyl-, Trimethoxysilyl-propyl- und Trimethoxysilyl-methyl-.

Beispiele für bevorzugte, die oben genannten Reste enthaltende olefinisch ungesättigte Verbindungen (b) sind: 4-Trimethylsilyl-styrol, Trimethylsilyloxy-styrol, t-Butyl-dimethylsilyloxy-styrol, Trimethylsilylmethacrylat, Trimethylsilylmethyl-methacrylat, 3-Methacryloxypropyl-bis-(trimethylsiloxy)methylsilan, 3-Methacryloxy-propylpentamethyldisiloxan, 3-Methacryloxypropyl-tris-(trimethylsiloxy)-silan, 3-Methacryloxypropyl-trimethoxysilan und 2-(Trimethylsilyl)-ethyl-methacrylat.
Komponente (b) ist im erfindungsgemäßen Copolymerisat in einer Menge von 95 bis 50, vorzugsweise 91 bis 55 Mol.% einpolymerisiert.
(c) Als copolymerisierbare olefinisch ungesättigte Carbonsäuren mit 3 bis 6 Kohlenstoffatomen eignen sich die üblichen copolymerisierbaren Mono-und Dicarbonsäuren, beispielsweise Acrylsäure, Methacrylsäure, Maleinsäure, Fumarsäure, Crotonsäure, Itaconsäure und/oder Methylenglutarsäure. Bevorzugt als Komponente (c) ist Methacrylsäure.
Diese Monomeren erhöhen die Löslichkeit in dem wäßrigen bzw. alkalischen Entwickler und tragen somit zur Erniederung der Belichtungszeit bei, da die zur Löslichkeitsdifferenzierung nötige Carbonsäurezahl nicht ausschließlich photochemisch erzeugt werden muß. Daneben tragen diese Monomeren ebenfalls zur Erhöhung der thermischen Stabilität bei, indem sie die Glastemperatur der Copolymeren anheben.
Komponente (c) ist im erfindungsgemäßen Copolymerisat in einer Menge von 0 bis 20, vorzugsweise 1 bis 15 Mol.% einpolymerisiert.
(d) Die erfindungsgemäßen Copolymerisate können noch weitere von (a), (b) und (c) verschiedene olefinisch ungesättigte, copolymerisierbare organische Verbindungen, deren Homopolymerisate im Wellenlängenbereich zwischen 250 und 400 nm transparent sind, einpolymerisiert enthalten. Beispiele für derartige Verbindungen sind: Vinylaromaten, wie Styrol und substituierte Styrole, Ethylen bzw. Diene, $C_1$-bis $C_8$-Alkylester der unter (c) genannten Carbonsäuren, z.B. Butylmethacrylat, Methylmethacrylat, das bevorzugt ist, Hydroxy-$C_2$-bis $C_6$-alkylester der unter (c) genannten Carbonsäuren, sowie andere Derivate der unter (c) genannten Carbonsäuren, z.B. Acrylamid, Methacrylamid und deren N-alkylsubstituierten Derivate sowie Gemische der aufgeführten Verbindungen. Durch Mitverwendung dieser Monomeren können Grundlöslichkeit in den Entwicklern und thermische Stabilität der Resiste erhöht werden.
Die Monomeren (d) können in Mengen von 0 bis 25, vorzugsweise 0 bis 20 Mol% im erfindungsgemäßen Copolymerisat einpolymerisiert sein.

Die Summe der unter (a) bis (d) genannten Prozentzahlen ist 100. Der Siliziumgehalt des erfindungsgemäßen Copolymerisates ist >6 Gewichtsprozent.

Die erfindungsgemäßen Copolymerisate können nach gängigen und an sich bekannten Methoden, wie z.B. der radikalischen Polymerisation aus den Monomeren (a) bis (d) hergestellt werden.

Die radikalische Polymerisation wird im allgemeinen so durchgeführt, daß man die Monomeren in einem geeigneten Lösungsmittel (z.B. Ethylacetat, Toluol, Tetrahydrofuran) löst und die von Sauerstoff befreite Lösung mit einem Polymerisationsinitiator wie Azo-isobutyronitril oder Benzoylperoxid versetzt und unter Inertgasatmosphäre bei Temperaturen im Bereich zwischen 30 und 120 °C mehrere Stunden erhitzt. Wie bereits oben erwähnt, muß das Monomerverhältnis des Silizium enthaltenden Monomeren (b) zu photosensitiven o-Nitrocarbinolester-Monomeren (a) und weiteren Comonomeren (c) + (d) so gewählt sein, daß im resultierenden Copolymeren mindestens ein Siliziumgehalt von 6 Gew.% erhalten wird. Die Menge an o-Nitrocarbinolester-Monomeren kann in Abhängigkeit von den gewünschten Eigenschaften in den oben angegebenen Grenzen variieren, ist aber so zu wählen, daß die Polymeren nach der bildmäßigen Belichtung in wäßrigen Lösungsmitteln, wie z.B. Wasser oder wäßrig-alkalischen Lösungsmitteln löslich werden und das Monomerverhältnis zur Siliziumkomponente einen Siliziumanteil >6 Gew.% im Polymeren ergibt. Bevorzugt werden o-Nitrocarbinolester-Monomere im Bereich von 8 bis 30 Mol.% eingebaut.

Die Molekulargewichte der resultierenden Polymeren sollen zweckmäßigerweise im Bereich von 10 000 bis 200 000 liegen. Besonders günstig ist eine enge Molekulargewichtsverteilung. Während Molekulargewichte unter 10 000 einen unerwünscht hohen Abtrag der unbelichteten Bereiche ergeben und teilweise nicht filmbildend sind, wird bei Molekulargewichten von über 200 000 die Löslichkeit in den wäßrig bzw. wäßrig alkalischen Lösungsmitteln herabgesetzt und auflösungsbegrenzende Quellung beobachtet.

Die erfindungsgemäßen Copolymerisate eignen sich besonders zur Herstellung von Zweilagenresisten. Die erfindungsgemäß herzustellenden Zweilagenresiste enthalten eine Planarisierungsschicht als unter Lage und eine obere Schicht aus den erfindungsgemäßen Copolymerisaten, die nach bildmäßiger Belichtung in wäßrigen bzw. alkalischen Lösungsmitteln auswaschbar sind und deren so erhaltene Reliefstrukturen die Übertragung des Musters mittels Sauerstoffplasma in die Planarisierungsschicht erlauben.

Die untere Planarisierungsschicht braucht nicht photoempfindlich zu sein und ist zweckmäßigerweise ein handelsüblicher ausgehärteter Diazochinon-Novolak-Resist, Polymethylmethacrylat oder ein Polyimid. Die Dicke der Planarisierungsschicht richtet sich nach der Höhe der Stufen auf dem Substrat, wobei üblicherweise in der Halbleiterfertigung hergestellte Substrate bei Planarisierungsschichtdicken oberhalb 1

μm eine planare Oberfläche ergeben. Eine Beschreibung der Mehrlagentechnik findet man z.B. in "Introduction to Microlithography, ACS Symp. Ser. 219, L.F. Thompson, C.G. Willson, M.J. Bowden, Eds., American Chemical Soc., Washington DC., 1983" in Kapitel 6 "Multi Layer Resist System".

Die Dicke der oberen, lichtempfindlichen Schicht hängt von der gewünschten Auflösung ab. Die Auflösung wird generell besser, je dünner die Schicht ist. Anwendbar sind Resistschichten von 0,2 μm bis 1 μm. Die gewünschten Schichtdicken sowohl der unteren als auch der oberen Schicht lassen sich unter Anwendung der konventionellen Spincoating-Technik erzeugen. Das Material der unteren Schicht, beispielsweise eine Lösung eines Novolak-Resists, kann mit Hilfe der Spincoating-Technik aufgesponnen werden, wobei die Schichtdicke bei konstanter Viskosität über die Drehzahl des Spinners eingestellt werden kann. Die resultierende Schicht kann dann bei Temperaturen >160 °C ausgebacken werden. Diese ausgebackene Schicht darf sich dann nicht in dem Lösungsmittel für das Polymere der oberen Schicht lösen.

Die obere Lage wird im allgemeinen ebenfalls mit Spincoating aufgebracht, wobei die Polymeren zweckmäßigerweise in Konzentration von 10 bis 30 Gew.% in beispielsweise Diethylenglykoldimethylether bei Schleudergeschwindigkeiten von 1000 bis 8000 Umdrehungen/min in der gewünschten Schichtdicke aufgebracht werden.

Zur Strukturierung des erfindungsgemäßen Zweilagenresists wird das obere, photoempfindliche Polymer mit DUV-Licht im Wellenlängenbereich von 190 nm bis 300 nm, bevorzugt 248 nm, bildmäßig belichtet. Die Belichtungsdosis liegt im allgemeinen im Bereich von 100 $mJ/cm^2$ bis 3000 $mJ/cm^2$ und muß so gewählt werden, daß die Dosis gerade ausreicht, um im nachfolgenden Entwicklungsschritt die belichteten Bereiche vollständig abzutragen, so daß die darunter liegende Planarisierungsschicht freigelegt ist. Die Entwicklung wird mit Wasser bzw. wäßrig-alkalischen Lösungsmitteln, wie 0,1 % Natriumhydrogencarbonatlösung, 0,2 % Tetramethylammoniumhydroxid, 3 % Triethanolamin/2 % Butylglykol u.a., durchgeführt. Die Entwicklerstärke wird so gewählt, daß der Abtrag in den unbelichteten Bereichen möglichst gering ist und 10 % nicht übersteigt.

Nachdem in der oberen Schicht die Reliefstrukturen hergestellt wurden, dienen diese als Maske für den Transfer der Strukturen in die Planarisierungsschicht mit einem Sauerstoffplasma. Die Sauerstoffplasmatechnik ist z.B. in dem oben bereits erwähnten Kapitel der "Introduction to Microlithography" beschrieben.

Im Parallelplattenreaktor werden im allgemeinen folgende Bedingungen angewandt: Gasdruck 4-20 Pa (30 mTorr bis 150 mTorr), Leistung des Hochfrequenzgenerators 50 W bis 300 Watt, so daß unter diesen Bedingungen Ätzraten von 500 $10^{-10}$ m/min (Å/min) bis 3000 $10^{-10}$ m/min (Å/min) für die Planarisierungsschicht resultieren. Der ebenfalls geeignete Barrelreaktor (= z.B. Plasmareaktor der Fa. Technics) wird typischerweise mit 500 Watt und einem Gasdruck von 86,645 Pa (650 mTorr) betrieben.

Nachdem das Maskenmuster in die Planarisierungsschicht übertragen worden ist, können die weiteren Verfahrensschritte zur Herstellung von Halbleiterbauelementen, wie Ätzen, Metallisierung, Dotierung, angewandt werden. Der Resist wird dann gestrippt und die Herstellung des gewünschten Bauelements zu Ende geführt.

Die erfindungsgemäßen lichtempfindlichen Copolymerisate sind besonders vorteilhaft für die Belichtung im DUV-Bereich geeignet, da die o-Nitrobenzylgruppe ein Absorptionsmaximum $\lambda$ = 258 nm hat. Sie sind nach Belichtung wäßrig- bzw. wäßrig-alkalisch auswaschbar und resistent im Sauerstoffplasma. Die erzeugten Resistmuster lassen sich daher mit Sauerstoffplasmen maskengetreu übertragen. Die erfindungsgemäßen Copolymerisate sind daher ideal als lichtempfindliche Materialien für Zweilagenresiste im DUV-Bereich geeignet.

Die in den folgenden Beispielen angegebenen Teile und Prozente sind, soweit nicht anders angegeben, Gewichtsteile und Gewichtsprozente.

Beispiel 1

Herstellung der Copolymerisate:

A. 7,1 Teile o-Nitro-α-methylbenzylmethacrylat, 42,8 Teile Trimethylsilyl-methacrylat (von Fa. Petrarch Systems) und 7,5 Teile Methacrylsäure werden in 125 Teilen Ethylacetat gelöst, 1 Stunde unter $N_2$-Atmosphäre auf Rückflußtemperatur erhitzt, 0,064 Teile Azoisobutyronitril zugegeben und weitere 8 Stunden bei ca. 80 °C gehalten. Nach dem Abkühlen wird das Polymere in ca. 2000 Teilen Ligroin ausgefällt. Das Polymere wird abgesaugt und im Vakuum getrocknet. Die Analyse ergibt einen Gehalt an o-Nitro-α-methylbenzylmethacrylat von 13,4 Mol.% und einen Siliziumgehalt von 6,7 %.

B. 9,4 Teile o-Nitro-α-methylbenzylmethacrylat und 20 Teile Trimethylsilylmethacrylat werden in 20 Teilen Toluol gelöst. Nach Erhitzen für eine Stunde unter $N_2$-Atmosphäre werden 0,195 Teile Benzoylperoxid zugegeben und 8 Stunden bei 80 °C polymerisiert. Die Analyse des Polymeren ergibt einen

Siliziumgehalt von 8,4 %.

C. Die Polymerisation wird analog Beispiel 1 A durchgeführt. Als Monomere werden jedoch 2,35 Teile o-Nitro-α-methylbenzylmethacrylat, 1,72 Teile Methacrylsäure und 29,5 Teile 3-Methacryloxy-propyl-tris-(trimethylsiloxy)-silan eingesetzt. Die Analyse ergibt einen Siliziumgehalt von 21,1 %.

D. (Vergleich)

Polymerisation und Monomere werden analog Beispiel 1 C eingesetzt, jedoch nur 6,0 Teile 3-Methacryloxy-propyl-tris-(trimethylsiloxy)-silan. Elementaranalyse ergibt einen Siliziumgehalt von 4,3 %.

E. (Vergleich)

Als Vergleich für die Bestimmung der Sauerstoffplasmaresistenz wird ein Copolymeres aus 2,8 Teilen o-Nitro-α-methylbenzylmethacrylat, 2,4 Teilen Methacrylsäure, 9,5 Teilen Methylmethacrylat und 1,95 Teilen Hydroxyethyl-methacrylat hergestellt.

Beispiel 2

Eine 20 %ige Lösung des nach Beispiel 1 A hergestellten Polymeren in Diethylenglykol-dimethylether wird durch ein Filter (Porendurchmesser ca. 0.2 µm) filtriert und mit 1450 U/min auf eine oxidierte Siliziumscheibe aufgeschleudert. Nach Ausheizen für 30 Minuten bei 160 °C resultiert eine Schichtdicke von ca. 1,0 µm. Nach Belichtung mit einem Excimer-Laser (λ = 248 nm, KrF) können die belichteten Bereiche mit reinem Wasser ausgewaschen werden, wenn die Belichtungsenergie mindestens 2500 $mJ/cm^2$ beträgt.

Beispiel 3

Etwa 1 µm dicke Schichten der Polymeren aus Beispiel 1 A-E sowie handelsübliche Produkte, wie Polymethylmethacrylat (= PMMA) und ein Novolak-Positivresist werden auf $SiO_2$-Wafer aufgeschleudert, 10 Minuten bei 120 °C getrocknet und in einem Barrelreaktor mit reinem Sauerstoffplasma geätzt. Der Reaktor wird mit 500 W Leistung und einem Sauerstoffdruck von 86,645 Pa (650 mTorr) betrieben. Die Ätzraten sind in Tabelle 1 zusammengestellt.

Tabelle I

| Polymer | Siliziumgehalt % | Ätzrate [Å/min] [$10^{-10}$ m/min] |
|---|---|---|
| PMMA | 0 | 1 700 |
| 1 E (Vergleich) | 0 | 1 500 |
| Novolak-Positivresist | 0 | 610 |
| 1 D | 4,3 | 840 |
| 1 A | 6,7 | 150 |
| 1 B | 8,4 | 120 |
| 1 C | 21,1 | 42 |

Beispiel 4

Die unterschiedlichen Ätzraten eines siliziumhaltigen Polymeren (1 B), eines nichtsiliziumhaltigen o-Nitrobenzylmethacrylat-Polymeren als Vergleichssystem (1 E) und der Polymeren für die zu strukturierende Planarisierungsschicht sind in Tabelle II zusammengestellt. Von den Polymeren werden jeweils etwa 1 µm dicke Schichten auf oxidierte Siliziumwafer aufgebracht. Die Polymeren aus Beispiel 1 B, als siliziumhaltiges Polymer, und Beispiel 1 E, als Vergleichssystem, werden 10 Minuten bei 120 °C, Polyimid wird 30 Minuten bei 200 °C, ein handelsüblicher Novolak-Positivresist 30 Minuten bei 140 °C und PMMA 30 Minuten bei 160 °C ausgeheizt. Die beschichteten Wafer werden auf die untere Elektrode eines Parallelplattenreaktors der Fa. Plasma-Technology gelegt und bei verschiedenen Sauerstoffdrücken geätzt, um die Ätzraten der photoempfindlichen Oberschicht (1 B) und der Planarisierungsschichten zu ermitteln.

Tabelle II

| Ätzrate von Polymeren im Sauerstoffplasma (100 W) | | | | |
|---|---|---|---|---|
| Polymer | Ätzrate [Å/min] bei verschiedenen Sauerstoffdrücken | | | |
| | 4 Pa (30 mTorr) | 6,665 Pa (50 mTorr) | 13,33 Pa (100 mTorr) | 20 Pa (150 mTorr) |
| PMMA | 1810 | 2150 | 2770 | 2770 |
| 1 E | 1810 | 2120 | 2600 | 2850 |
| Novolak-Positivresist | 1000 | 1300 | 1470 | 1670 |
| Polyimid | 560 | 640 | 750 | 870 |
| 1 B | 53 | 70 | 51 | 104 |

Beispiel 5

Auf oxidierte Siliziumwafer werden unterschiedliche Schichtdicken des gemäß Beispiel 1 C hergestellten Polymeren aufgebracht, indem 10 %ige bzw. 15 %ige Lösungen in Diethylenglykoldimethylether durch Anpassung der Umdrehungszahl des Spincoaters in Schichtdicken von ca. 0,3 µm bis 1 µm aufgeschleudert werden. Die Wafer werden dann im Sauerstoffplasma in einem Parallelplattenreaktor so lange unter Bedingungen geätzt, unter denen eine typische 2 µm Planariserungsschicht, beispielsweise Novolak-Positivresist, vollständig abgetragen wird. Ausgangsschichtdicke und Dicke nach der Ätzung werden mit einem $\alpha$-step Profilometer gemessen. Die Ergebnisse sind in Tabelle III angeführt. Der Reaktor wird unter folgenden Bedingungen betrieben: 13,33 Pa (100 mTorr) Sauerstoffdruck und 100 Watt Leistung.

Tabelle III

| Schichtdicke des Resists gemäß Beispiel 1 C in Abhängigkeit von der Ätzzeit im Sauerstoffplasma 13,33 Pa (100 mTorr, 100 W) | | | | |
|---|---|---|---|---|
| Konzentration % | U/min | Schichtdicke in [µm] | | |
| | | vor | nach 6 Minuten Ätzen | nach 15 Minuten |
| 15 | 2000 | 1,08 | 0,93 | 0,91 |
| 15 | 6000 | 0,80 | 0,65 | 0,64 |
| 15 | 6000 | 0,80 | 0,66 | 0,64 |
| 10 | 1000 | 0,61 | 0,30 | 0,09 |
| 10 | 2500 | 0,39 | 0,10 | 0,09 |
| 10 | 5000 | 0,32 | 0,08 | 0,07 |

Beispiel 6

Eine 20 %ige Lösung des gemäß Beispiel 1 C hergestellten Polymeren in Cyclopentanon wird mit 5000 U/min auf einen oxidierten Siliziumwafer aufgeschleudert, wobei eine Schichtdicke von 1,34 µm resultiert. Der beschichtete Wafer wird dann 2 Minuten bei 120 °C auf einer Heizplatte ausgeheizt und danach unter Verwendung eines Excimer Lasers mit monochromatischem Licht ($\lambda$ = 248 nm, KrF) belichtet. Eine chrombeschichtete Quarzplatte mit unterschiedlichen Transmissionsbereichen dient als Kontaktmaske. Die abgestufte Maske bewirkt eins Belichtung verschiedener Bereiche mit zunehmender Lichtmenge. Die geringste Dosis, die notwendig ist, um den gesamten Film in den belichteten Bereichen abzulösen, wird als Empfindlichkeit definiert (Tabelle IV).

Tabelle IV

| Entwicklung des Resists gemäß Beispiel 1 C in verschiedenen wäßrig-alkalischen Entwicklern | | | | |
|---|---|---|---|---|
| Entwickler: Base und organische Komponenten (Gehalt) | Bel.-zeit (sek) | Entwickl.-zeit (sek) | pH-Wert | Empfindlichkeit ($mJ/cm^2$) |
| Triethanolamin (3 %), Butylglykol (2 %) | >50 | 60 | 10,3 | >1750 |
| Triethanolamin (4 %), Isopropanol (10 %), Acetylaceton (5 %) | 30 | 60 | 8,1 | 1050 |
| Tetramethylammoniumhydroxid (0,2 %) | 15 | 30 | 12,6 | 500 |

Beispiel 7

Ein oxidierter Siliziumwafer wird mit einer 1 µm dicken Schicht eines kommerziell erhältlichen Positivresists auf Novolak-Basis überzogen und 30 Minuten bei 180 °C ausgeheizt. Eine Lösung des in Beispiel 1 A hergestellten Polymeren wird hergestellt und mit 3000 U/min auf das mit handelsüblichem Novolak-Positivresist beschichtete Substrat aufgebracht. Das Substrat wird danach für 10 Minuten bei 120 °C ausgeheizt und durch eine mit Chromstrukturen beschichtete Quarzmaske mit Licht eines Excimer Lasers bei λ = 248 nm belichtet. Die belichteten Bereiche werden mit Wasser herausgelöst. Der Wafer wird dann auf die untere Elektrode eines Parallelplattenreaktors gelegt und 10 Minuten bei einem Sauerstoffpartialdruck von 50 mTorr im Sauerstoffplasma behandelt. Dabei wird die untere Planarisierungsschicht komplett an den belichteten Stellen abgetragen.

**Patentansprüche**

**1.** Copolymerisate, die einpolymerisiert enthalten
(a) 5 bis 50 Mol.% mindestens einer Verbindung der allgemeinen Formel (I)

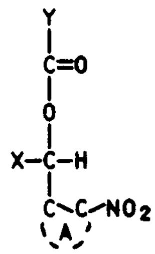

(I),

worin A für ein aromatisches oder heteroaromatisches, gegebenenfalls substituiertes Ringsystem mit 5 bis 14 Ringgliedern,
X für Wasserstoff, einen Alkylrest mit 1 bis 8 Kohlenstoffatomen, einen gegebenenfalls substituierten Aryl- oder Aralkylrest und
Y für einen ethylenisch ungesättigten Rest mit 2 bis 6 Kohlenstoffatomen stehen,
(b) 95 bis 50 Mol.% mindestens einer copolymerisierbaren olefinisch ungesättigten Silizium enthaltenden organischen Verbindung,
(c) 0 bis 20 Mol.% einer oder mehrerer copolymerisierbarer olefinisch ungesättigter Carbonsäuren mit 3 bis 6 Kohlenstoffatomen,
(d) 0 bis 25 Mol.% einer oder mehrerer weiterer von (a), (b) und (c) verschiedener olefinisch ungesättigter, copolymerisierbarer organischer Verbindungen, deren Homopolymerisate im Wellenlängenbereich zwischen 250 und 400 nm transparent sind,

mit der Maßgabe, daß die Summe der unter (a) bis (d) genannten Prozentzahlen 100 ist, und das Copolymerisat einen Siliziumgehalt von >6 Gew.% aufweist.

2. Copolymerisate nach Anspruch 1, dadurch gekennzeichnet, daß der Rest Y in der allgemeinen Formel (I) für einen der Reste

$-CH{=}CH_2$ , 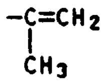 , $-CH{=}CH{-}COOH$ , $-CCl{=}CCl{-}COOH$ , 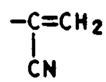 ,

$-CH{=}CHCH_3$ , 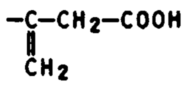 , 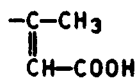 , 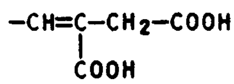 oder

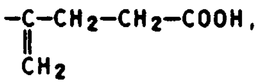

steht.

3. Copolymerisate nach Anspruch 1 oder 2, dadurch gekennzeichnet, daß in der allgemeinen Formel (I) der Rest A für Phenyl, der Rest X für Methyl und der Rest Y für eine

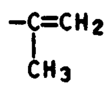

Gruppe steht.

4. Copolymerisate nach einem der Ansprüche 1 bis 3, dadurch gekennzeichnet, daß das der o-Nitrocarbinolestergruppierung der Formel (I) zugrundeliegende Carbinol o-Nitrobenzylalkohol, Nitro-6-chlorbenzylalkohol, 2-Nitro-4-cyanobenzylalkohol, α-Methyl-o-nitrobenzylalkohol, α-Phenyl-o-nitrobenzylalkohol oder α-(o-Nitrophenyl)-o-Nitrobenzylakohol ist.

5. Copolymerisate nach einem der vorhergehenden Ansprüche, dadurch gekennzeichnet, daß der o-Nitrocarbinolester der allgemeinen Formel (I) ein Ester der Acrylsäure, Methacrylsäure, Maleinsäure, Fumarsäure oder Crotonsäure ist.

6. Copolymerisate nach einem der vorhergehenden Ansprüche, dadurch gekennzeichnet, daß die copolymerisierbare olefinisch ungesättigte Silizium enthaltende Verbindung (b) ein Derivat des Styrols oder α-Methylstyrols ist.

7. Copolymerisate nach Anspruch 6, dadurch gekennzeichnet, daß die copolymerisierbare olefinisch ungesättigte Silizium enthaltende Verbindung (b) 4-Trimethylsilylstyrol ist.

8. Copolymerisate nach einem der Ansprüche 1 bis 5, dadurch gekennzeichnet, daß die copolymerisierbare olefinisch ungesättigte Silizium enthaltende Verbindung (b) ein Derivat der Acrylsäure oder Methacrylsäure ist.

9. Copolymerisate nach Anspruch 8, dadurch gekennzeichnet, daß die copolymerisierbare olefinisch ungesättigte Silizium enthaltende Verbindung (b) mindestens ein siliziumhaltiges Monomer ausgewählt aus der Gruppe Trimethylsilylmethacrylat, Trimethylsilylmethyl-methacrylat, 3-Methacryloxypropyl-bis-(trimethylsiloxy)-methylsilan, 3-Methacryloxy-propylpentamethyldisiloxan, 3-Methacryloxypropyl-tris-(trimethylsiloxy-)silan, 3-Methacryloxypropyl-trimethoxysilan und 2-(Trimethylsilyl)-ethyl-methacrylat ist.

10. Copolymerisate nach einem der vorhergehenden Ansprüche, dadurch gekennzeichnet, daß sie als Komponente (c) Acrylsäure oder Methacrylsäure einpolymerisiert enthalten.

11. Copolymerisate nach einem der vorhergehenden Ansprüche, dadurch gekennzeichnet, daß sie als Komponente (d) Ester der Acrylsäure oder Methacrylsäure mit 1 bis 8 Kohlenstoffatome enthaltenden

Monoalkanolen und/oder Hydroxyalkyl(meth)acrylate einpolymerisiert enthalten.

**12.** Verfahren zur Herstellung der Copolymerisate nach einem der Ansprüche 1 bis 11, dadurch gekennzeichnet, daß die unter (a) bis (d) genannten Verbindungen in Gegenwart radikalliefernder Initiatoren polymerisiert werden.

**13.** Verfahren zur Herstellung eines Zweilagenresists, dadurch gekennzeichnet, daß als untere Lage ein im Sauerstoffplasma abbaubares Polymer und als obere Schicht ein Copolymerisat gemäß einem der Ansprüche 1 bis 11 eingesetzt wird.

**14.** Verfahren zur Herstellung eines Zweilagenresists nach Anspruch 13, dadurch gekennzeichnet, daß das Copolymerisat gemäß einem der Ansprüche 1 bis 11 strukturiert und das Muster mit Hilfe eines Plasmas in die untere Schicht übertragen wird.

**15.** Verfahren nach Anspruch 14, dadurch gekennzeichnet, daß als Plasma ein Sauerstoffplasma eingesetzt wird.

**16.** Verfahren zur Herstellung von Halbleiterbauelementen, wobei man ein lichtempfindliches Material auf ein Substrat aufträgt, das lichtempfindliches Material bildmäßig belichtet, wäßrig alkalisch entwickelt, mit Hilfe eines Plasmas weiterentwickelt und die Herstellung des Halbleiterbauelementes in üblicher Weise zu Ende führt, dadurch gekennzeichnet, daß man als lichtempfindliches Material ein Copolymerisat nach einem der Ansprüche 1 bis 11 verwendet.

## Claims

**1.** A copolymer containing as copolymerized units
(a) from 5 to 50 mol % of one or more compounds of the general formula (I)

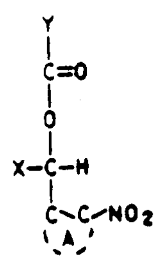

(I).

where A is an aromatic or hetaromatic, substituted or unsubstituted ring system of 5 to 14 ring members,
X is hydrogen, alkyl of 1 to 8 carbon atoms or substituted or unsubstituted aryl or aralkyl, and
Y is an ethylenically unsaturated radical of 2 to 6 carbon atoms,
(b) from 95 to 50 mol % of one or more copolymerizable olefinically unsaturated silicon-containing organic compounds,
(c) from 0 to 20 mol % of one or more copolymerizable olefinically unsaturated carboxylic acids of 3 to 6 carbon atoms,
(d) from 0 to 25 mol % of one or more further olefinically unsaturated, copolymerizable organic compounds other than (a), (b) and (c), whose homopolymers are transparent within the wavelength region from 250 to 400 nm,
with the proviso that the sum of the percentages mentioned under (a) to (d) is 100 and the copolymer has a silicon content of > 6 % by weight.

**2.** A copolymer as claimed in claim 1, wherein the radical Y in the general formula (I) is one of the radicals

$-CH=CH_2$ , 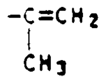 , $-CH=CH-COOH$ , $-CCl=CCl-COOH$ , 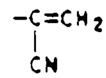 ,

$-CH=CHCH_3$ , 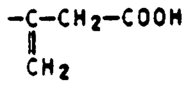 , 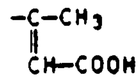 , 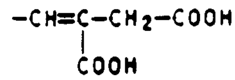 and

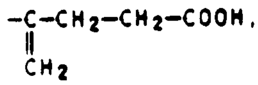

**3.** A copolymer as claimed in claim 1 or 2, wherein, in the general formula (I), A is phenyl, X is methyl and Y is a

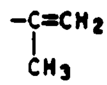

group.

**4.** A copolymer as claimed in any of claims 1 to 3, wherein the parent carbinol to the o-nitrocarbinol ester group of the formula (I) is o-nitrobenzyl alcohol, nitro-6-chlorobenzyl alcohol, 2-nitro-4-cyanobenzyl alcohol, α-methyl-o-nitrobenzyl alcohol, α-phenyl-o-nitrobenzyl alcohol or α-(o-nitrophenyl)-o-nitrobenzyl alcohol.

**5.** A copolymer as claimed in any of the preceding claims, wherein the o-nitrocarbinol ester of the general formula (I) is an ester of acrylic acid, of methacrylic acid, of maleic acid, of fumaric acid or of crotonic acid.

**6.** A copolymer as claimed in any of the preceding claims, wherein the copolymerizable olefinically unsaturated silicon-containing compound (b) is a derivative of styrene or α-methylstyrene.

**7.** A copolymer as claimed in claim 6, wherein the copolymerizable olefinically unsaturated silicon-containing compound (b) is 4-trimethylsilylstyrene.

**8.** A copolymer as claimed in any of claims 1 to 5, wherein the copolymerizable olefinically unsaturated silicon-containing compound (b) is a derivative of acrylic or methacrylic acid.

**9.** A copolymer as claimed in claim 8, wherein the copolymerizable olefinically unsaturated silicon-containing compound (b) comprises one or more silicon-containing monomers selected from the group consisting of trimethylsilyl methacrylate, trimethylsilylmethyl methacrylate, 3-methacryloyloxypropylbis-(trimethylsiloxy)methylsilane, 3-methacryloyloxypropylpentamethyldisiloxane, 3-methacryloyloxypropyltris(trimethylsiloxy)silane, 3-methacryloyloxypropyltrimethoxysilane and 2-(trimethylsilyl)ethyl methacrylate.

**10.** A copolymer as claimed in any of the preceding claims, which contains as component (c) acrylic or methacrylic acid as copolymerized units.

**11.** A copolymer as claimed in any of the preceding claims, which contains as component (d) an ester of acrylic or methacrylic acid with a monoalkanol of 1 to 8 carbon atoms and/or a hydroxyalkyl (meth)-acrylate as copolymerized units.

**12.** A process for preparing a copolymer as claimed in any of claims 1 to 11, which comprises polymerizing the compounds mentioned under (a) to (d) in the presence of a free radical initiator.

13. A process for producing a two-layer resist, which comprises using as the lower layer a polymer which is degradable in oxygen plasma and as the upper layer a copolymer as claimed in any of claims 1 to 11.

14. A process for producing a two-layer resist as claimed in claim 13, wherein the copolymer as claimed in any of claims 1 to 11 is structured and a pattern is transferred into the lower layer by means of a plasma.

15. A process as claimed in claim 14, wherein the plasma used is an oxygen plasma.

16. A process for fabricating a semiconductor device by applying a light-sensitive material to the substrate, subjecting said light-sensitive material to imagewise exposure, aqueous alkaline development and further development by means of a plasma, and completing fabrication of the semiconductor device in a conventional manner, which comprises using as the light-sensitive material a copolymer as claimed in any of claims 1 to 11.

## Revendications

1. Copolymères contenant, à l'état polymérisé :
a) 5 à 50 moles % d'au moins un composé de formule générale I

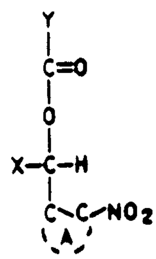

(I),

dans laquelle A représente un système cyclique aromatique ou hétéroaromatique éventuellement substitué de 5 à 14 chaînons cycliques,
X représente l'hydrogène, un groupe alkyle en C 1-C 8, un groupe aryle ou aralkyle éventuellement substitué, et
Y représente un groupe à insaturation éthylénique en C 2-C 6,
b) 95 à 50 moles % d'au moins un composé organique à insaturation oléfinique copolymérisable contenant du silicium,
c) 0 à 20 moles % d'un ou plusieurs acides carboxyliques à insaturation oléfinique copolymérisables en C 3-C 6,
d) 0 à 25 moles % d'un ou plusieurs autres composés organiques variés à insaturation oléfinique, autres que a), b) et c), copolymérisables, dont les homopolymères sont transparents dans l'intervalle des longueurs d'ondes de 250 à 400 nm, la somme des pourcentages indiqués sous a) à d) étant égale à 100, et sous réserve que le copolymère soit à une teneur en silicium supérieure à 6 % en poids.

2. Copolymères selon la revendication 1, caractérisés en ce que le symbole Y de la formule générale I représente l'un des groupes

$-CH=CH_2$ , 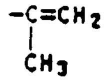 , $-CH=CH-COOH$ , $-CCl=CCl-COOH$ , 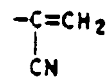 ,

$-CH=CHCH_3$ , 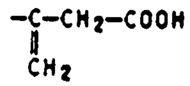 , 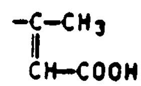 , 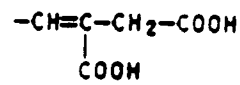 ou

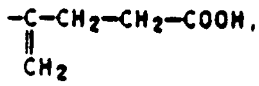

**3.** Copolymères selon la revendication 1 ou 2, caractérisés en ce que, dans la formule générale I, le symbole A représente un groupe phényle, le symbole X un groupe méthyle et le symbole Y un groupe

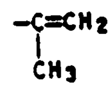

**4.** Copolymères selon une des revendications 1 à 3, caractérisés en ce que le carbinol dont dérive le groupement ester d'o-nitrocarbinol de formule I est l'alcool o-nitrobenzylique, l'alcool nitro-6-chlorobenzylique, l'alcool 2-nitro-4-cyano-benzylique, l'alcool alpha-méthyl-o-nitrobenzylique, l'alcool alpha-phényl-o-nitro-benzylique ou l'alcool alpha-(o-nitrophényl)-o-nitrobenzylique.

**5.** Copolymères selon une des revendications qui précèdent, caractérisés en ce que l'ester d'o-nitrocarbinol de formule générale I est un ester de l'acide acrylique, de l'acide méthacrylique, de l'acide maléique, de l'acide fumarique ou de l'acide crotonique.

**6.** Copolymères selon une des revendications qui précèdent, caractérisés en ce que le composé à insaturation oléfinique copolymérisable, contenant du silicium b) est un dérivé du styrène ou de l'alpha-méthylstyrène.

**7.** Copolymères selon la revendication 6, caractérisés en ce que le composé à insaturation oléfinique copolymérisable contenant du silicium b) est le 4-triméthylsilylstyrène.

**8.** Copolymères selon une des revendications 1 à 5, caractérisés en ce que le composé à insaturation oléfinique copolymérisable contenant du silicium b) est un dérivé de l'acide acrylique ou de l'acide méthacrylique.

**9.** Copolymères selon la revendication 8, caractérisés en ce que le composé à insaturation oléfinique copolymérisable contenant du silicium b) consiste en au moins un monomère silicié choisi dans le groupe formé par le méthacrylate de triméthylsilyle, le méthacrylate de triméthylsilylméthyle, le 3-méthacryloxypropyl-bis-(triméthylsiloxy)-méthylsilane, le 3-méthacryloxypropylpentaméthyldisiloxane, le 3-méthacryloxypropyl-tris-(triméthylsiloxy)-silane, le 3-méthacryloxypropyltriméthoxysilane et le méthacrylate de 2-(triméthylsilyl)-éthyle.

**10.** Copolymères selon l'une des revendications qui précèdent, caractérisés en ce qu'ils contiennent en tant que composant c) l'acide acrylique ou l'acide méthacrylique à l'état polymérisé.

**11.** Copolymères selon une des revendications qui précèdent, caractérisés en ce qu'ils contiennent en tant que composant d) des esters de l'acide acrylique ou méthacrylique et de monoalcanols en C 1-C 8 et/ou des (méth)acrylates d'hydroxyalkyle à l'état polymérisé.

**12.** Procédé de préparation des copolymères selon une des revendications 1 à 11, caractérisé en ce que l'on polymérise les composés mentionnés sous a) à d) en présence d'inducteurs radicalaires.

**13.** Procédé de préparation d'une réserve à deux couches, caractérisé en ce que l'on utilise en couche inférieure un polymère dégradable dans le plasma d'oxygène et en couche supérieure en copolymère selon une des revendications 1 à 11.

**14.** Procédé de préparation d'une réserve à deux couches selon la revendication 13, caractérisé en ce que le copolymère selon une des revendications 1 à 11 est structuré et le modèle est transféré dans la couche inférieure à l'aide d'un plasma.

**15.** Procédé selon la revendication 14, caractérisé en ce que le plasma utilisé est un plasma d'oxygène.

**16.** Procédé pour la fabrication d'éléments de structure simi-conducteurs dans lequel on applique un matériau photosensible sur un support, on expose la matière photosensible à la lumière avec formation d'une image, on la développe en milieu aqueux alcalin, on poursuit le développement à l'aide d'un plasma et on achève la fabrication de l'élément de structure semi-conducteur de la manière habituelle, caractérisé en ce que l'on utilise en tant que matériau photosensible un copolymère selon une des revendications 1 à 11.